# EUROPEAN PATENT APPLICATION

(11) **EP 4 002 009 A1**
(43) Date of publication of application: **25.05.2022**
(21) Application number: 20206889.6
(22) Date of filing: 11.11.2020
(51) Int. Cl.: G03F 7/20, G02B 7/18, G02B 26/08

(54) **A METHOD AND APPARATUS FOR THERMALLY DEFORMING AN OPTICAL SURFACE OF AN OPTICAL ELEMENT**

(71) Applicant: ASML Netherlands B.V., 5500 AH Veldhoven (NL)
(72) Inventor: VAN DEN BRINK, Marinus Aart, 5500 AH Veldhoven (NL)
(74) Representative: ASML Netherlands B.V.

(57) **Abstract**

A method of thermally deforming an optical surface of an optical element, the optical element comprising a material whose coefficient of thermal expansion is zero at a zero crossing temperature, the method comprising: transferring heat from the optical element using a heat sink to establish one or more temperature set points for one or more of a plurality of regions of the optical element such that the sign of the coefficient of thermal expansion is the same for the majority or all of the material of the one or more of the plurality of regions of the optical element over the majority or all of a heating activation range of a heater, and selectively heating the one or more of the plurality of regions of the optical element over the heating activation range to produce a specific thermal deformation at the one or more of the plurality of regions of the optical element using the heater.

## Description

### FIELD

The present invention relates to a method and apparatus for thermally deforming an optical surface of an optical element. More particularly, the method and apparatus relates to thermally deforming an optical surface of an optical element to correct aberrations.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The projection system which is used to image the pattern from a patterning device onto the substrate will induce some aberrations in the wavefront of the projected image.

During the projection of the pattern onto the substrate, the projection system will heat up, and this will cause the imaging properties of the projection system to drift. In EUV lithography, this phenomenon is called mirror heating.

Although mirrors in the projection system are optimized for EUV radiation transmission, a significant part of EUV (but also out-of-band) energy is absorbed in the mirrors and transformed into heat. This heating causes thermal stresses in the material of the mirrors leading to deformations of the optical surfaces. These deformations finally cause aberrations in the projection system causing imaging errors. In addition, the heating, either directly or indirectly, may cause thermal stresses in the material of other components, such as lenses, substrate clamps, patterning devices (i.e. reticles or masks) or patterning device clamps.

It is an object of the invention to provide a method for correcting aberrations which obviates or mitigates one or more problems associated with the prior art.

### SUMMARY

According to a first aspect of the invention, there is provided a method of thermally deforming an optical surface of an optical element, the optical element comprising a material whose coefficient of thermal expansion is zero at a zero crossing temperature, the method comprising: transferring heat from the optical element using a heat sink to establish one or more temperature set points for one or more of a plurality of regions of the optical element such that the sign of the coefficient of thermal expansion is the same for the majority or all of the material of the one or more of the plurality of regions of the optical element over the majority or all of a heating activation range of a heater, and selectively heating the one or more of the plurality of regions of the optical element over the heating activation range to produce a specific thermal deformation at the one or more of the plurality of regions of the optical element using the heater.

This may have an advantage of introducing corresponding thermal deformations to the optical surface of the optical surface during use of the lithographic apparatus LA to correct aberrations, e.g. caused by other optical elements of the lithographic apparatus LA.

The method may further comprise establishing the one or more temperature set points such that a change in the heat from the heater results in a change in the thermal deformation in a range of - 10nm to +10nm for the one or more of the plurality of regions of the optical element over the majority or all of the heating activation range of the heater.

The one or more temperature set points may be established such that the change in the heat from the heater results in a relatively large change in the thermal deformation for the one or more of the plurality of regions of the optical element over the majority or all of the heating activation range of the heater.

The one or more temperature set points may be established such that the relationship between heat load and deformation has sufficient sensitivity to provide a relatively good range of thermal manipulation. A larger deviation between temperature set point and zero crossing temperature may result in a larger sensitivity.

The one or more temperature set points may be established such that there is an approximate linear dependency between the temperature and the thermal deformation of the one or more of the plurality of regions of the optical element over a majority or all of the heating activation range of the heater. The thermal deformation may be considered to be deformation normal to the optical surface.

For optical element manipulation, Zernike actuation steps between substrates may be in the order of 0.01nm.

The method may further comprise establishing the one or more temperature set points such that the coefficient of thermal expansion has a value that is substantially similar for the plurality of regions of the optical element over the majority or all of the heating activation range of the heater.

The method may further comprise establishing the one or more temperature set points in a range of 1-8 degrees C from the zero crossing temperature.

The zero crossing temperature of the material may comprise local zero crossing temperatures for the one or more of the plurality of regions of the optical element or an average zero crossing temperature for the optical element.

The one or more temperature set points may be greater than the zero crossing temperature of the material or the one or more temperature set points may be less than the zero crossing temperature of the material.

The plurality of regions of the optical element may be defined between the optical surface of the optical element and the heat sink.

The variation of the zero crossing temperature of the material on the side of the heat sink opposite the optical surface of the optical element may be considered to be less relevant than in the plurality of regions.

The thermal disturbance of the optical element on the side of the heat sink opposite the optical surface of the optical element may be considered to be negligible and may not be taken into account.

The method may further comprise determining the relationship between the heat from the heater provided to the one or more of the plurality of the regions of the optical element and the resultant thermal deformation of the corresponding one or more local sections of the optical surface of the optical element.

The method may further comprise calibrating the heater using corresponding optical measurements taken by an optical measurement apparatus.

The method may further comprise calibrating the heater using corresponding wavefront aberration measurements taken by a wavefront sensor.

The method may further comprise using the calibrated heater during EUV radiation exposure of the optical element to manipulate the wavefront during operation of a lithographic apparatus.

The method may further comprise using the calibrated relationship between the heat from the heater and the resulting thermal deformation of the one or more of the plurality of regions of the optical element to introduce a corresponding thermal deformation to the optical surface of the optical element via the heater during use of the lithographic apparatus. This may be used to correct aberrations, e.g. caused by other optical elements of the lithographic apparatus.

The method may further comprise determining the one or more temperature set points based on provided or determined zero crossing temperatures.

The method may further comprise characterising the distribution of the zero crossing temperatures of the optical surface of the optical element by modelling.

The method may further comprise setting a temperature of a cooling fluid of the heat sink to establish the one or more temperature set points of the optical element.

The temperature of the cooling fluid may be greater and the one or more temperature set points may be less than the zero crossing temperature of the material or the temperature of the cooling fluid may be less and the one or more temperature set points may be greater than the zero crossing temperature of the material. That is, the temperature of the cooling fluid and the one or more temperature set points may be on different sides with respect to the zero crossing temperature of the material.

The temperature of the cooling fluid may be substantially the same as the zero crossing temperature of the material and the one or more temperature set points may be less than or greater than the zero crossing temperature of the material.

The method may further comprise heating one or more local sections of the optical surface of the optical element corresponding to the one or more of the plurality of regions of the optical element.

The coefficient of thermal expansion may be a function of the temperature of the optical element and the optical element temperature may be a function of the cooling fluid temperature. The one or more temperature set points may be established by setting the temperature of the cooling fluid sufficiently far away from the zero crossing temperature of the material of the optical element.

The temperature of the cooling fluid may be set at, example ranges of +/-0.5 C, +/-1 C, or +/-2 C away from the zero-crossing temperature Tzc in view of the zero-crossing temperature Tzc variations.

The temperature of the cooling fluid may equal the average zero-crossing temperature. This situation may not be preferred as it may require extra power when compared to the case where the temperature of the cooling fluid is set away from the zero-crossing temperature Tzc.

The plurality of regions of the optical element may be defined between the optical surface of the optical element and at least one channel in the optical element for the cooling fluid.

The heater may comprise a sector heater with a plurality of sectors arranged to correspondingly heat the one or more of the plurality of regions of the optical element.

Each sector may have a heating actuation range per sector. The heating activation range of one of the plurality of sectors may be the same or may be different to another of the plurality of sectors. The actuation range of a given sector may map to a certain range of wavefront aberrations at substrate level.

The method may further comprise calibrating the plurality of sectors of the sector heater using corresponding optical measurements taken by an optical measurement apparatus. The optical measurements may be wavefront aberration measurements taken by a wavefront sensor.

The method may further comprise modifying the power for the plurality of sectors of the sector heater in turn and taking the corresponding optical measurements. That is, the power is altered for the plurality of sectors of the sector heater one by one. This may determine how the wavefront is changed by the change in temperature of the corresponding region of the optical element.

The relationship between power to the sectors of the sector heater and the corresponding optical measurements may be used for thermal manipulation of the wavefront.

According to a second aspect of the present invention, there is provided an apparatus comprising: at least one optical element comprising a material whose coefficient of thermal expansion is zero at a zero crossing temperature, a heat sink arranged to transfer heat from the optical element to establish one or more temperature set points for one or more of a plurality of regions of the optical element such that the sign of the coefficient of thermal expansion is the same for the majority or all of the material of the one or more of the plurality of regions of the optical element over the majority or all of a heating activation range of a heater, the heater arranged to: selectively heat one or more of the plurality of regions of the optical element over the heating activation range to produce a specific thermal deformation at the one or more of the plurality of regions of the optical element.

The one or more temperature set points may be established such that a change in the heat from the heater results in a change in the thermal deformation in a range of -10 to +10nm for the one or more of the plurality of regions of the optical element over the majority or all of the heating activation range of the heater.The apparatus of either of claims 18-19, wherein the heater is arranged to heat one or more local sections of the optical surface of the optical element corresponding to the one or more of the plurality of regions of the optical element.

The heater may include a source of electromagnetic waves producing the thermal deformation of the one or more of the plurality of regions of the optical element.

The heat sink may comprise cooling fluid for passing through at least one channel in the optical element.

The plurality of regions of the optical element may be defined between the optical surface of the optical element and the at least one channel in the optical element for the cooling fluid.

The heater may comprise a sector heater with a plurality of sectors arranged to correspondingly heat the one or more of the plurality of regions of the optical element.

The optical element may be a mirror.

According to a third aspect of the present invention, there is provided a lithographic apparatus comprising a projection system configured to project a radiation beam to project a pattern from a patterning device onto a substrate, wherein the lithographic apparatus comprises the apparatus as described above.

The lithographic apparatus may be an EUV lithographic apparatus and the projection system may comprise mirrors.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a schematic diagram of a mirror and heater of the lithographic apparatus in accordance with an embodiment of the invention.
- Figure 3 depicts a graph of local mirror optical surface temperature against deformation normal to the optical surface of the mirror in accordance with an embodiment of the invention.
- Figure 4 depicts a graph of local mirror optical surface temperature against deformation normal to the optical surface of the mirror in accordance with an embodiment of the invention.
- Figure 5 depicts a flow diagram of a method of deforming an optical surface of a mirror.

### DETAILED DESCRIPTION

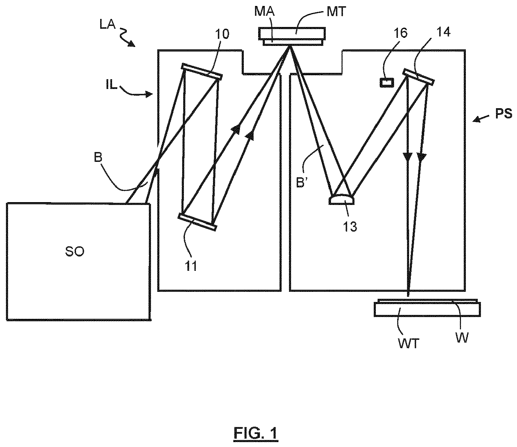

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Optical surface deformation may occur in mirrors in the projection system PS of the EUV lithographic apparatus LA. More generally, surface deformation may occur in components in the EUV lithographic apparatus LA. It will be appreciated that, although the following description generally relates to a mirror or mirrors in the projection system PS in the EUV lithographic apparatus LA, the methods described are also applicable to other components in the EUV lithographic apparatus LA and other components in other lithographic apparatus, such as a DUV lithographic apparatus. For example, the component may be an optical element, a mirror, a projection system mirror, an illumination system mirror, a lens, a projection system lens, an illumination system lens.

To reduce the deformations causing aberrations in the projection system PS, the mirror material is optimized for minimum deformations using ultra-low expansion (ULE) material. This material exhibits a quadratic expansion relation with temperature, which has almost-zero expansion properties around its design temperature, known as the zero-crossing temperature (Tzc or ZCT). The mirror top side (the side which the radiation beam B' is incident upon) may be kept as close to this Tzc as possible to minimize deformations. Due to more aggressive heat loads (higher power, more extreme illumination profiles) it is not possible to keep the full mirror surface around this sweet spot. The mirror material may be made of other materials that have a relatively low or very low, coefficient of thermal expansion (CTE), e.g. ZERODUR or Cordierite.

Optical surface deformation is very sensitive to the local (typically non-uniform) irradiance (heat load) and the (local) zero-crossing Temperature (Tzc). A particular irradiance may provide a uniform temperature across the surface of the material which results in a well-correctable bending of the optical surface - i.e. strain in material. On the other hand, non-uniform irradiance (a different particular irradiance) may provide isolated areas of relatively increased temperature which results in a mainly non-correctable deformation of optical surface - i.e. strain in material.

Non-linear thermal expansion curves may be shown for zero-crossing temperatures Tzc (ZCT). For each curve, there may be a trough at the Tzc and, thus, the curve may be relatively gradual around the Tzc. This means that, at, or near, the Tzc there is relatively little thermal expansion.

Deformation may be larger for an example Tzc than for another example Tzc because the mirror environment is maintained at (reference) temperature (for example -22°C). Thus, the deformation is very sensitive to the particular Tzc.

Manufacturing tolerance has a large impact on spatial variation of Tzc. This may result in a manufacturing tolerance on the average Tzc.

Spatial variations of Tzc may be measured, e.g. measured on a mirror. There may be a change in temperature in °C (or in Kelvin). There may be spatial variations of typically several Kelvins in the mirror. In some projection systems PS of some lithographic apparatus LA, some mirrors may have a particular variation whereas other mirrors may have a different variation. The spatial variations of Tzc may be calculated by measuring the material's coefficient of linear thermal expansion (CTE), e.g. by using ultrasound.

The impact of this non-uniform Tzc on the performance of the projection system PS is large. This may be shown by comparing optical key performance indicators for uniform Tzc and non-uniform Tzc.

In a lithographic apparatus LA, incoming electro-magnetic (EM) waves (i.e. EUV radiation) interact with mirror(s) with some of the radiation being reflected and some absorbed. The absorbed radiation is dissipated within the mirror which leads to mirror heating. Heat is conducted within the mirror and thus the mirror temperature changes over time, e.g. increases. The temperature changes cause the mirror to deform which leads to wavefront aberrations. These wavefront aberrations may need to be corrected in the lithographic apparatus LA.

With increasing EUV radiation source powers, mirror heating becomes an increasing problem in EUV lithographic apparatus LA. In particular the mirrors of the projection optics (e.g. projection system PS) may heat up too much, deform and cause aberrations that cannot be corrected sufficiently.

During operation of an EUV lithographic apparatus LA mirrors (e.g. in the projection system PS) may be exposed to EUV radiation. A (pre)heater may establish a constant heat load to the mirrors 13, 14 irrespective of the presence and spatial distribution (illumination modes) of the EUV radiation.

Typically the EUV radiation is incident on different locations on the mirrors 13, 14 such that there is a spatially non-uniform heat load. The EUV radiation may be using a dipole illumination mode for example so that certain parts of the mirrors 13, 14 are not hit by EUV radiation. In addition, the EUV radiation may be on some of the time and off at other times. Preheaters may be used to heat the mirrors 13, 14 such that the spatial heat load distribution at the mirror surface is stable over time. One particular spatial heat load distribution may be uniform, another spatial heat load distribution may be non-uniform. Some preheaters may try to maintain the average temperature of the mirror's optical footprint at some predefined value. In absence of any EUV radiation the temperature would be uniform inside the footprint, which in view of boundary conditions requires a spatially *non-uniform* irradiance. This mirror preheating tries to control the average temperature of an optical footprint of the mirrors 13, 14 to minimize aberrations. The preheaters may be IR heaters so that the radiation will not affect the imaging on the substrate W. A heater 16 (e.g. a preheater) for mirror 14 is shown in Figure 1. It will be appreciated that there may be a plurality of heaters and there may be one or a plurality of heaters for each mirror or, more generally, each optical element.

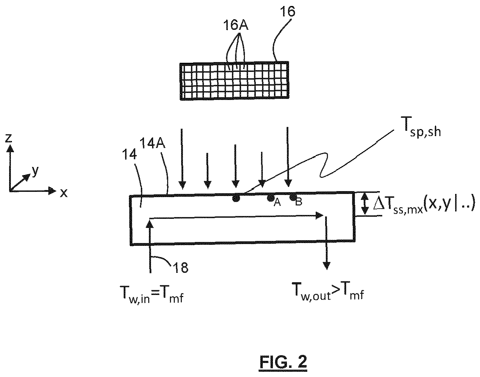

Figure 2 depicts a schematic diagram of the mirror 14 of the projection system PS of the lithographic apparatus LA with the heater 16. The heater 16 may have a relatively high spatial resolution, e.g. is a barcode scanner or sector heater with a relatively large number of sectors 16A. For example, the sector heater may have a range of e.g. 10-200 sectors, or 20-100 sectors. The upper limit of sectors may be motivated from the degrees of freedom of the illuminator IL (order of magnitude). The sectors 16A of the heater 16 allow different parts of the mirror 14 to be heated with different amounts of heat and/or at different times. To achieve this, the sectors 16A may be provided with different levels of power over time. That is, the power for one or more of the sectors 16A may be modified to provide different levels of heat to different parts of the mirror 14 as depicted by the downward facing arrows of differing lengths in Figure 2. The sectors 16A may have the same physical size or may be different sizes. The sectors 16A are shown as boxes to illustrate an array-like arrangement, since the irradiance is 2D in space. However, it will be appreciated that, in other embodiments, the sectors may have any suitable shape.

The heater 16 includes a source of electromagnetic waves (e.g. IR) to heat the mirror 14. It will be appreciated that, in other embodiments, a heater may heat the mirror in other ways, e.g. a heater may be imbedded within the mirror, more particularly there may be a grid of resistive wires in the mirror.

The mirror 14 has an optical surface 14A which is configured to reflect the EUV radiation. The optical surface 14A may include a reflective (multilayer) coating.

The mirror 14 has temperature set points, e.g. (T_{sp,sh}), with 'sp' being set point and 'sh' being sector heating. More particularly, there are one or more temperature set points of one or more of a plurality of regions of the mirror 14. For example, location A, corresponding to one region of the mirror 14, may have a different temperature set point than location B, corresponding to another region of the mirror 14. The heater 16 may heat one or more local sections of the optical surface 14A of the mirror 14 to heat the plurality of regions of the mirror 14. As an example, if there are 100 local sections of the optical surface for a pupil-like mirror then for a mirror which has ∼80mm diameter of optical footprint it may have local sections of the optical surface that are ∼50 mm² in size. For larger mirrors this size may be ∼500 mm².

The mirror 14 includes water cooling. At least one channel (not shown) is provided in the mirror 14 for passing cooling water 18, or more generally cooling fluid, through the mirror 14. The cooling water 18 may be input to the mirror 14 at a temperature T_{w,in} =T_{mf} and, after extracting heat from the mirror 14, may exit from the mirror 14 at temperature T_{w,out} greater than T_{mf}. T_{mf} is the ambient temperature of the mirror 14 made from the ULE material (e.g. ∼22°C). More generally, the cooling water 18 may be considered to be a heat sink arranged to transfer heat from the optical element (mirror 14). The cooling water 18 heats up (convection) and transports heat away from the mirror 14. In other embodiments, it will be appreciated that the heat sink may take a different form.

The cooling water 18 reduces stationary state deformation because of reduced stationary state temperature difference (ΔTₛₛ) and also reduces intrawafer drift because of Tzc reoptimization and reduced thermal penetration. Stationary state temperature difference (ΔTₛₛ) varies per position (x,y) and, without cooling, is a function of the EUV-induced heat load and the boundary conditions. The EUV-induced heat load is a function of EUV radiation source power, the lithographic apparatus LA duty cycle, mask properties (pattern density, reflectivity), illumination pupil, the mirror's EUV absorption coefficient, and the mirror's position along the optical path (and the coupling between mirror and environment): ΔT_{ss,mx}= max(ΔTₛₛ(x,ylQₑᵤᵥ, Pupil)).

As mentioned previously, zero-crossing Temperature (Tzc) varies spatially due to material inhomogeneity. Variation of the Tzc of the part below the cooling (i.e. the cooling water 18) may be considered to be less relevant than the variation of the Tzc in the part between the cooling (i.e. the cooling water 18) and the optical surface 14A of the mirror 14. The cooling design is assumed to be such that thermal disturbance of the bulk below the cooling is negligible. This implies zero-crossing temperature (Tzc) variation within that part of the mirror 14 is less critical compared to that of the top part (i.e. between cooling and coating of the optical surface 14A). The latter may be calibrated on the lithographic apparatus LA. Variation of the Tzc within the part between cooling and coating implies in principle distinct actuator sensitivities between any two locations, e.g. location A and B. This requires calibration.

Previously a heater may have been used to heat mirrors such that they are uniformly heated, both spatially and over time to keep the heat load constant. However, in embodiments, the heater 16 is arranged to selectively heat one or more of a plurality of regions of the mirror 14 over a heating activation range to produce a specific thermal deformation at the one or more of the plurality of regions of the mirror 14. That is, additional functionality has been added to the heater 16 to deliberately induce a desired thermal deformation of the mirror 14 by means of which aberrations caused by other mirrors or modules can be corrected. This may be considered to be thermal manipulation of the mirror 14 by the heater 16, i.e. the heater 16 may be considered to be a thermal manipulator. The heating activation range may be considered to be the specified range of heat which the heater 16 may provide to the mirror 14. The heating activation range may relate to a minimum and maximum power limit for the heater 16, which may be set. The heater may have different heating activation ranges for different sectors 16A of the heater 16. An implementation with similar ranges for each sector 16A may be chosen. However, certain sectors 16A may be designed with less power, e.g. because the local EUV load is orders of magnitude smaller compared to other spots on the mirror, or because that spot is not as relevant from an aberration manipulator perspective.

The local sections of the optical surface 14A of the mirror 14 correspond to the plurality of the regions of the mirror 14. The heater 16 heats the one or more local sections of the optical surface 14A of the mirror 14 corresponding to the plurality of the regions of the mirror 14.

The plurality of regions of the mirror 14 may be defined between the optical surface 14A of the mirror 14 and the cooling (or more precisely, the channel for the cooling water 18). This is because the variation of the zero-crossing temperature of the material on the side of the cooling water 18 opposite the optical surface 14A of the mirror 14 may be considered to be less relevant than in the plurality of regions of the mirror 14. The thermal disturbance of the mirror 14 on the side of the cooling water 18 opposite the optical surface 14A of the mirror 14 may be considered to be negligible and may not be taken into account.

As can be seen in Figure 2, the stationary state temperature difference ΔTₛₛ(x,yl..), which varies per position (x, y) - i.e. a position across the optical surface 14A of the mirror 14, is taken from the position of the cooling water 18. That is, the stationary state temperature of the mirror 14 is taken from a depth z (e.g. 5mm from the optical surface of the mirror 14) corresponding to the location of the cooling.

The cooling water 18 is arranged to transfer heat from the mirror 14 (to the environment) to establish temperature set points of the mirror 14. More particularly, one or more temperature set points for one or more of a plurality of regions of the optical element may be established. The one or more temperature set points may be set away from the zero-crossing temperature (Tzc) of the material of the mirror 14 such that the sign of the coefficient of thermal expansion (CTE) is the same for the plurality of regions of the mirror 14 over a majority or all of the heating activation range of the heater 16. The cooling water 18 acts as a heat sink. The zero-crossing temperature of the material is the local zero-crossing temperatures for each of the plurality of the regions of the mirror 14. That is, defining all temperature set points at an equal offset from the local zero-crossing temperatures. This may provide similar nanometer-power sensitivity for each sector 16A. In other embodiments, the zero-crossing temperature of the material may be considered to be the average zero-crossing temperature of the mirror 14 (i.e. the mean for all of the plurality of regions of the mirror 14).

In embodiments, the one or more temperature set points may be established in a range of 1-8 degrees C from the zero-crossing temperature Tzc. A homogenous ULE material may have a +/-1C tolerance so it may be desired to set the temperature set point at approximately 1 degrees C from the zero-crossing temperature Tzc. As another example, the temperature set point may be set at approximately 4 degrees C from the zero-crossing temperature Tzc.

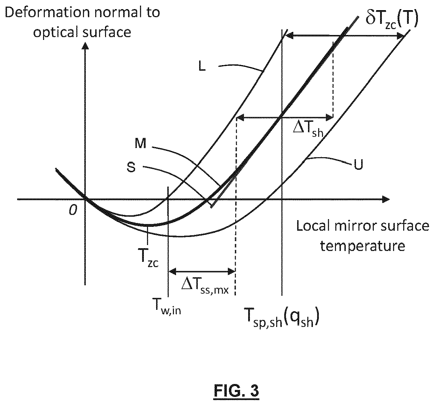

Figure 3 shows a graph which illustrates this. The graph shows local mirror optical surface 14A temperature (x axis) against deformation normal to the optical surface 14A of the mirror 14 (y-axis). It can be seen that, from the minimum temperature plotted, the deformation initially decreases with increasing temperature (i.e. having a negative coefficient of thermal expansion), before reaching a minimum (i.e. zero), and then the deformation increases with increasing temperature (i.e. having a positive coefficient of thermal expansion). The zero-crossing temperature (Tzc), where the ULE material has almost zero-expansion properties, corresponds with the minimum point. A main (bold) line M may be considered to be for an average zero-crossing temperature Tzc. The dashed lines U, L in the graph, corresponding to the main line M of the graph, show the upper U and lower L limit due to the variation of the zero-crossing temperature of the material δT_{zc}(T). The variation of zero-crossing temperature Tzc in the material is intrinsic yet deterministic.

It can be seen that both the temperature setpoint T_{sp,sh}(qₛₕ) and the cooling temperature T_{w,in} of the mirror 14 are on the same side with respect to the zero crossing temperature Tzc (i.e. at the same side of the parabola). In this case the temperature setpoint T_{sp,sh}(qₛₕ) and the cooling temperature T_{w,in} of the mirror 14 are both greater than the zero crossing temperature Tzc. It will be appreciated that, in other embodiments, the temperature setpoint T_{sp,sh}(qₛₕ) and the cooling temperature T_{w,in} of the mirror 14 may be both less than the zero crossing temperature Tzc, i.e. both on the other side of the zero crossing temperature Tzc from that shown in Figure 3.

In Figure 3, the coolant temperature T_{w,in} is slightly above the zero-crossing temperature Tzc as shown. This setup may be preferable to the coolant temperature T_{w,in} being on the other side of the zero crossing temperature Tzc from the temperature setpoint T_{sp,sh}(qₛₕ). This may be because this may make sure that the minimum point of the thermal expansion coefficient (i.e. the Tzc) would not be reached and thus the sign of the thermal expansion coefficient of the region of the mirror 14 would not be different from the other regions of the mirror 14.

Higher flow rate of the cooling water 18 implies more disturbances to the mirror 14 and that introduces aberrations. So, in practice, it may be desired to minimize the temperature setpoint T_{sp,sh}(qₛₕ) as much as possible so that there is enough activation range (to carry out the necessary thermal manipulation). Once a certain sector 16A of the heater 16 is off, it means that the heating activation range has been exceeded for that particular section of the optical footprint.

There is a section of the graph where the slope of the line M indicates a linear or almost linear relationship between the deformation and the temperature (see straight line S which illustrates this). That is, there is an approximate linear dependency between the temperature and the thermal deformation of the region of the mirror 14 over a majority or all of the heating activation range (ΔTₛₕ) of the (sector) heater 16. The vertical dashed lines show the extent of the heating activation range ΔTₛₕ of the (sector) heater 16. The maximum temperature offset between cooling (i.e. the cooling water 18) and front side (i.e. the optical surface 14A), ΔT_{ss,mx} is determined by the highest local power density among the relevant EUV loads at a given source power. The upper limit of the manipulator control range ΔTₛₕ is determined by the maximum actuation range required for correcting the worst of EUV-heating- or non-heating-induced aberrations.

The temperature set point (T_{sp,sh}(qₛₕ)) is established in the approximate linear dependency section of the graph, with q being the heat flux from the sector heater 16 in watts per square meter. It can be seen that the temperature set point T_{sp,sh}(qₛₕ) is located sufficiently far away from the zero-crossing temperature (Tzc) such that for all of the heating activation range of the sector heater (heater 16), the coefficient of thermal expansion is positive. It will be appreciated, that in other embodiments, this may not be the case for all of the heating activation range ΔTₛₕ and may only be for a majority of the heating activation range.

It can be seen that the temperature set point T_{sp,sh}(qₛₕ) is located sufficiently far away from the zero-crossing temperature (Tzc) such that for the full variation of the zero-crossing temperature of the material δT_{zc}(T), the coefficient of the thermal expansion is positive. Thus, even if the sector 16A of the sector heater 16 was set at the lowest power and the zero-crossing temperature Tzc was at its highest possible value due to the spatial variation for a particular region of the mirror 14, the minimum point of the thermal expansion coefficient (i.e. the Tzc) would not be reached and thus the sign of the thermal expansion coefficient of the region of the mirror 14 would not be different from the other regions of the mirror 14. It will be understood that if the mirror temperature corresponding to a particular region of the mirror 14 was such that the Tzc was reached, and passed, then the sign of the coefficient of thermal expansion would not be the same and the deformation would be opposite for that region when compared to the regions in which the Tzc was not reached and passed.

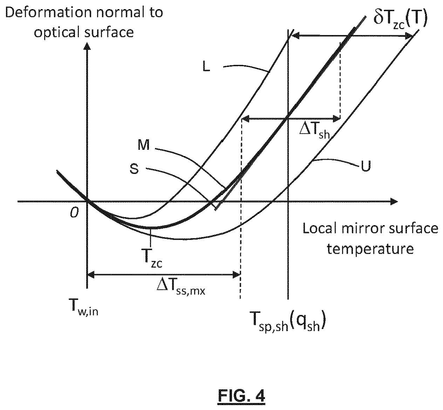

Figure 4 depicts another graph showing local mirror optical surface 14A temperature (x axis) against deformation normal to the optical surface 14A of the mirror 14 (y-axis). The graph of Figure 4 is similar to the graph of Figure 3, except, in the graph of Figure 4, the temperature setpoint T_{sp,sh}(qₛₕ) and the cooling temperature T_{w,in} of the mirror 14 are on different sides with respect to the zero crossing temperature Tzc (i.e. at different sides of the parabola). In this case the temperature setpoint T_{sp,sh}(qₛₕ) is greater than the zero crossing temperature Tzc and the cooling temperature T_{w,in} of the mirror 14 is less than the zero crossing temperature Tzc. More particularly, 0 on the x-axis corresponds to the temperature T_{w,in} of the cooling water 18 at the inlet to the mirror 14. T_{w,in} is preferably close to or equal to the temperature of the mirror 14 (made of ULE material) (T_{mf}).

In this embodiment, the temperature setpoint T_{sp,sh}(qₛₕ) is still away from the zero-crossing temperature Tzc of the material of the mirror 14 such that the sign of the coefficient of thermal expansion is the same for a majority or all of the material of the regions of the mirror 14 over a majority or all of the heating activation range of the heater 16. In embodiments, a minority of the material of the regions of the mirror 14 may not have the same sign coefficient of thermal expansion (CTE). This may be the part of the material closest to the cooling water 18.

In embodiments, the temperature of the cooling water may equal the average zero-crossing temperature Tzc provided the one or more temperature set points are sufficiently away from the average zero-crossing temperature Tzc (e.g. by about +4 C) such that the majority of the material between the optical surface of the mirror and the cooling water has the same sign coefficient of thermal expansion (CTE). In this case, the part of the material closest to the cooling water may not have the same sign coefficient of thermal expansion. This situation may not be preferred as it may require extra power when compared to the case where the temperature of the cooling fluid is set away from the zero-crossing temperature Tzc.

In general, the one or more temperature set points for the one or more of a plurality of regions of the optical element are established away from the zero-crossing temperature Tzc of the material of the mirror 14 such that the sign of the coefficient of thermal expansion is the same for the regions of the mirror 14 over a majority or all of the heating activation range of the heater 16. In some embodiments, the one or more temperature set points may be set such that the coefficient of thermal expansion has a value that is substantially similar for the regions of the mirror 14 over the majority or all of the heating activation range of the heater 16. That is, the coefficient of thermal expansion for the regions of the mirror 14 may have a comparable value - the deformation being of a comparable size between regions of the mirror 14.

The steady state temperature set point T_{sp,sh}(qₛₕ) during calibration is established at or near the middle of the heating activation range of the heater 16. The temperature set point T_{sp,sh}(qₛₕ) of the mirror 14 is established using the cooling water 18 transferring heat from the mirror 14. The temperature (T_{w,in}) of the cooling water 18 may be set at a particular amount to establish the desired temperature set point T_{sp,sh}(qₛₕ) of the mirror 14. The coefficient of thermal expansion (CTE) is a function of the temperature of the mirror 14 and the mirror 14 temperature is a function of the temperature of the cooling water 18. The temperature set point T_{sp,sh}(qₛₕ) may be established by setting the temperature (T_{w,in}) of the cooling water 18 sufficiently far away from the zero-crossing temperature (Tzc) of the material of the mirror 14. The temperature of the cooling water 18 may be set at, example ranges of +/-0.5 C, +/-1 C, or +/-2 C away from the zero-crossing temperature Tzc in view of the zero-crossing temperature Tzc variations.

If the cooling water 18 was not used to limit the temperature of the mirror 14 then, over time (i.e. due to exposure of EUV radiation and/or the heating by the heater 16), the temperature of the mirror 14 may increase by too much such that it is outside the range for thermal manipulation by the heater 16, i.e. the temperature would drift away.

The temperature set point T_{sp,sh}(qₛₕ) is established such that a change in the heat from the heater 16 results in a relatively large change in the thermal deformation for the region of the mirror 14 over all of the heating activation range of the heater 16 when compared to the thermal deformation around the Tzc. The relatively large change in the thermal deformation may be in a range of -10 to +10nm. For optical element manipulation, Zernike actuation steps between substrates may be of approximately 0.01nm. The temperature set point may be considered to be located sufficiently far away from the zero-crossing temperature Tzc such that the slope of line M in this section of the graph is relatively steep when compared to the slope of line M in the section of the graph around the Tzc.

The temperature set point T_{sp,sh}(qₛₕ) is established such that the relationship between heat load and deformation has sufficient sensitivity to provide a relatively good range of thermal manipulation. A larger deviation between temperature set point and zero-crossing temperature may result in a larger sensitivity. That is, a temperature set point being further away from the zero-crossing temperature, i.e. away from the lower part of line M of the graph, means that for the same increase in temperature, the deformation will be larger. This is advantageous as this means that a relatively large amount of thermal manipulation can be achieved for a relatively low power increase to the sector 16A of the sector heater 16.

The amount of thermal deformation of the mirror 14 for a particular power to the sector 16A may depend on cooling depth and size of the sector 16A. For example, with a cooling depth of 10mm and a sector size of 10mmx10mm, a sensitivity of 0.5nm/W may be found for ULE material. The distance in nanometers reflect surface figure deformation.

The temperature set points T_{sp,sh}(qₛₕ) may be based on provided or determined zero-crossing temperatures of the material of the mirror 14. That is, zero-crossing temperatures that have been measured, estimated or modelled. The method may comprise characterising the distribution of the zero-crossing temperatures Tzc of the optical surface 14A of the mirror 14 by modelling. That is, the local zero-crossing temperatures Tzc for the material of the mirror 14 may be individually determined and then used as the starting point to establish the temperature set points.

Once the desired temperature set point T_{sp,sh}(qₛₕ) has been reached the extra degrees of freedom of the heater 16 have to be calibrated. For each sector of the heater 16 a corresponding wavefront error has to be measured with a wavefront sensor (not shown). The wavefront sensor may take wavefront aberration measurements which take into account a variety of degrees of freedom, such as number of mirrors, position and orientation of mirrors and not only mechanical aspects. Thus, calibration is needed to determine how the thermal manipulation by the heater 16 affects the wavefront error.

More generally, the heater 16 may be calibrated using corresponding optical measurements taken by an optical measurement apparatus (e.g. the wavefront sensor). The plurality of sectors 16A of the sector heater 16 may be calibrated using corresponding optical measurements taken by the optical measurement apparatus (e.g. wavefront aberration measurements taken by the wavefront sensor).

The relationship between the heat from the heater 16 provided to the one or more of the plurality of the regions of the mirror 14 and the resultant thermal deformation of the corresponding one or more local sections of the optical surface 14A of the mirror 14 needs to be determined.

The method may include modifying the power for each of the plurality of sectors 16A of the sector heater 16 in turn and taking the corresponding optical measurements. That is, the power is altered for each the plurality of sectors 16A of the sector heater 16 one by one. This establishes a sensitivity curve, i.e. how the deformation changes with changing power for the sectors 16A (or activation zones). Taking the optical measurements allows a determination to be made on how the wavefront is changed by the change in temperature of the corresponding region of the mirror 14. The relationship between power to the sectors 16A of the sector heater 16 and the corresponding optical measurements may be used for thermal manipulation of the wavefront of the mirror 14. It will be appreciated that, in other embodiments, the calibration could be carried out in different ways.

In embodiments, checks may be made to verify that modifying one or more of the powers of the sectors 16A of the heater 16 to heat one or more regions of the mirror 14 may not substantially change (i.e. heat and deform) other regions of the mirror 14 which are not specifically being heated. If this was the case, then it would be difficult, or not possible, to get the necessary thermal actuation to correct aberrations etc. It may be desired to have independent sectors. If crosstalk to adjacent or neighbouring sectors is large it means that their response needs to be accounted for as well when actuating a given sector. This means this crosstalk, etc. would need to be calibrated.

During lot production (exposures) (i.e. during operation of the lithographic apparatus LA) the calibrated relations can then be used to manipulate the wavefront of the mirror 14 (or mirrors) by inducing a corresponding thermal deformation via the heater 16. The calibrated relationship between the heat from the heater 16 and the resulting thermal deformation of the one or more of the plurality of regions of the mirror 14 may be used to introduce a corresponding thermal deformation to the optical surface 14A of the mirror 14 via the heater 16 during use of the lithographic apparatus LA. This may be used to correct aberrations, e.g. caused by other optical elements of the lithographic apparatus LA. As an example, a power in the range of 5W to 10W provided to a sector 16A of the sector heater 16 may result in a 1nm change in the coefficients of Zernike wavefronts.

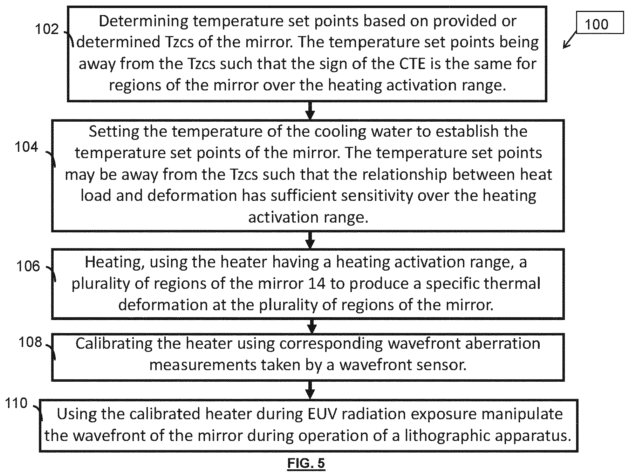

Figure 5 depicts a flow diagram 100 of a method of deforming an optical surface 14A of a mirror 14. That is, heating one or more regions of the mirror 14 to thermally manipulate the mirror 14, e.g. for correcting wavefront aberrations.

In step 102, temperature set points T_{sp,sh}(qₛₕ) are determined based on provided or determined zero-crossing temperatures of the material of the mirror 14. An alternative strategy may be to define a temperature T_{win} of cooling water 18 slightly above the zero crossing temperature Tzc, then compute the required temperature setpoint (depends on source power, illumination pupil, etc.), and add thermal range for manipulation - this is for the example shown in the graph of Figure 3. The temperature set points being away from the zero-crossing temperatures (Tzcs) such that the sign of the coefficient of thermal expansion (CTE) is the same for the plurality of regions of the mirror 14 over the heating activation range (e.g. all or the majority of the heating activation range) of the heater 16. The CTE may have a value that is substantially similar for the plurality of regions of the mirror 14 over the heating activation range (e.g. all or the majority of the heating activation range) of the heater 16.

In step 104, the temperature of the cooling water 18 is set to establish the temperature set points of the mirror 14. The temperature set points may be away from the Tzcs such that the relationship between heat load and deformation has sufficient sensitivity over the heating activation range.

In step 106, the plurality of regions of the mirror 14 are heated, using a heater 16 having a heating activation range, to produce a specific thermal deformation at the plurality of regions of the mirror 14.

In step 108, the heater 16 is calibrated using corresponding wavefront aberration measurements taken by a wavefront sensor.

In step 110, the calibrated heater 16 is used during EUV radiation exposure of the mirror 14 to manipulate the wavefront during operation of a lithographic apparatus LA.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of thermally deforming an optical surface of an optical element, the optical element comprising a material whose coefficient of thermal expansion is zero at a zero crossing temperature, the method comprising:
transferring heat from the optical element using a heat sink to establish one or more temperature set points for one or more of a plurality of regions of the optical element such that the sign of the coefficient of thermal expansion is the same for the majority or all of the material of the one or more of the plurality of regions of the optical element over the majority or all of a heating activation range of a heater, and
selectively heating the one or more of the plurality of regions of the optical element over the heating activation range to produce a specific thermal deformation at the one or more of the plurality of regions of the optical element using the heater.

2. The method of claim 1, further comprising establishing the one or more temperature set points such that a change in the heat from the heater results in a change in the thermal deformation in a range of -10nm to +10nm for the one or more of the plurality of regions of the optical element over the majority or all of the heating activation range of the heater.

3. The method of any preceding claim, further comprising establishing the one or more temperature set points such that the coefficient of thermal expansion has a value that is substantially similar for the plurality of regions of the optical element over the majority or all of the heating activation range of the heater.

4. The method of any preceding claim, further comprising establishing the one or more temperature set points in a range of 1-8 degrees C from the zero crossing temperature.

5. The method of any preceding claim, wherein the zero crossing temperature of the material comprises local zero crossing temperatures for the one or more of the plurality of regions of the optical element or an average zero crossing temperature for the optical element.

6. The method of any preceding claim, wherein the one or more temperature set points are greater than the zero crossing temperature of the material or the one or more temperature set points are less than the zero crossing temperature of the material.

7. The method of any preceding claim, wherein the plurality of regions of the optical element are defined between the optical surface of the optical element and the heat sink.

8. The method of any preceding claim, further comprising determining the relationship between the heat from the heater provided to the one or more of the plurality of the regions of the optical element and the resultant thermal deformation of the corresponding one or more local sections of the optical surface of the optical element.

9. The method of any preceding claim, further comprising calibrating the heater using corresponding optical measurements taken by an optical measurement apparatus.

10. The method of claim 9, further comprising calibrating the heater using corresponding wavefront aberration measurements taken by a wavefront sensor.

11. The method of either of claims 9 or 10, further comprising using the calibrated heater during EUV radiation exposure of the optical element to manipulate the wavefront during operation of a lithographic apparatus.

12. The method of any preceding claim, further comprising determining the one or more temperature set points based on provided or determined zero crossing temperatures.

13. The method of any preceding claim, further comprising setting a temperature of a cooling fluid of the heat sink to establish the one or more temperature set points of the optical element.

14. The method of any of claims 1-13, wherein the temperature of the cooling fluid is greater and the one or more temperature set points are less than the zero crossing temperature of the material or the temperature of the cooling fluid is less and the one or more temperature set points are greater than the zero crossing temperature of the material.

15. The method of any of claims 1-13, wherein the temperature of the cooling fluid is substantially the same as the zero crossing temperature of the material and the one or more temperature set points are less than or greater than the zero crossing temperature of the material.

16. The method of any preceding claim, further comprising heating one or more local sections of the optical surface of the optical element corresponding to the one or more of the plurality of regions of the optical element.

17. The method of any preceding claim, wherein the heater comprises a sector heater with a plurality of sectors arranged to correspondingly heat the one or more of the plurality of regions of the optical element.

18. An apparatus comprising:
at least one optical element comprising a material whose coefficient of thermal expansion is zero at a zero crossing temperature,
a heat sink arranged to transfer heat from the optical element to establish one or more temperature set points for one or more of a plurality of regions of the optical element such that the sign of the coefficient of thermal expansion is the same for the majority or all of the material of the one or more of the plurality of regions of the optical element over the majority or all of a heating activation range of a heater,
the heater arranged to:
selectively heat one or more of the plurality of regions of the optical element over the heating activation range to produce a specific thermal deformation at the one or more of the plurality of regions of the optical element.

19. The apparatus of claim 18, wherein the one or more temperature set points are established such that a change in the heat from the heater results in a change in the thermal deformation in a range of - 10 to +10nm for the one or more of the plurality of regions of the optical element over the majority or all of the heating activation range of the heater.

20. The apparatus of either of claims 18-19, wherein the heater is arranged to heat one or more local sections of the optical surface of the optical element corresponding to the one or more of the plurality of regions of the optical element.

21. The apparatus of any of claims 18-20, wherein the heater includes a source of electromagnetic waves producing the thermal deformation of the one or more of the plurality of regions of the optical element.

22. The apparatus of any of claims 18-21, wherein the heat sink comprises cooling fluid for passing through at least one channel in the optical element.

23. The apparatus of claim 22, wherein the plurality of regions of the optical element are defined between the optical surface of the optical element and the at least one channel in the optical element for the cooling fluid.

24. The apparatus of any of claims 18-23, wherein the heater comprises a sector heater with a plurality of sectors arranged to correspondingly heat the one or more of the plurality of regions of the optical element.

25. The apparatus of any of claims 18-24, wherein the optical element is a mirror.

26. A lithographic apparatus comprising a projection system configured to project a radiation beam to project a pattern from a patterning device onto a substrate, wherein the lithographic apparatus comprises the apparatus of any of claims 18 to 25.

27. The lithographic apparatus of claim 26, wherein the lithographic apparatus is an EUV lithographic apparatus and the projection system comprises mirrors.
